# EUROPEAN PATENT SPECIFICATION

(11) **EP 4 128 530 B1**
(45) Date of publication and mention of the grant of the patent: **19.08.2026**
(21) Application number: 20927605.4
(22) Date of filing: 05.10.2020
(51) Int. Cl.: H03F 1/02, H03F 1/07, H03F 3/20, H03G 3/30, H03F 3/60, H03F 3/24

(54) **AMPLIFIER CIRCUITS AND METHODS OF OPERATING AN AMPLIFIER CIRCUIT**
VERSTÄRKERSCHALTUNGEN UND VERFAHREN ZUM BETRIEB EINER VERSTÄRKERSCHALTUNG
CIRCUITS AMPLIFICATEURS ET PROCÉDÉS DE FONCTIONNEMENT D'UN CIRCUIT AMPLIFICATEUR

(30) Priority: 23.03.2020 WO PCT/SE2020/050300
(43) Date of publication of application: 08.02.2023
(73) Proprietor: TELEFONAKTIEBOLAGET LM ERICSSON (PUBL), 164 83 Stockholm (SE)
(72) Inventor: HELLBERG, Richard, 141 45 Huddinge (SE)
(74) Representative: Ericsson
(86) International application number: PCT/SE2020/050940
(87) International publication number: WO 2021/194402

(56) References cited:
- EP-A1- 2 849 277
- WO-A1-03/038995
- WO-A1-2005/031966
- WO-A1-2007/078217
- WO-A1-2011/134905
- WO-A1-2016/182485
- WO-A1-2019/091541
- US-A1- 2002 167 722
- US-A1- 2002 171 477
- US-A1- 2005 134 377

## Description

### Technical Field

Examples of the present disclosure relate to an amplifier circuits and methods of operating amplifier circuits.

### Background

Load modulated balanced amplifiers (LMBA) are power amplifiers (PA) that have high efficiency at low (backed off) amplitudes. Their efficiency vs amplitude curves may demonstrate an efficiency maximum at a backed off amplitude point. They may be similar to a traditional balanced amplifier (BA) but with a signal source instead of a resistive termination at one port of an output side 3-dB 90-degree hybrid (e.g. hybrid coupler). LMBAs operate in two distinct modes, separated in amplitude at certain level called the transition point.

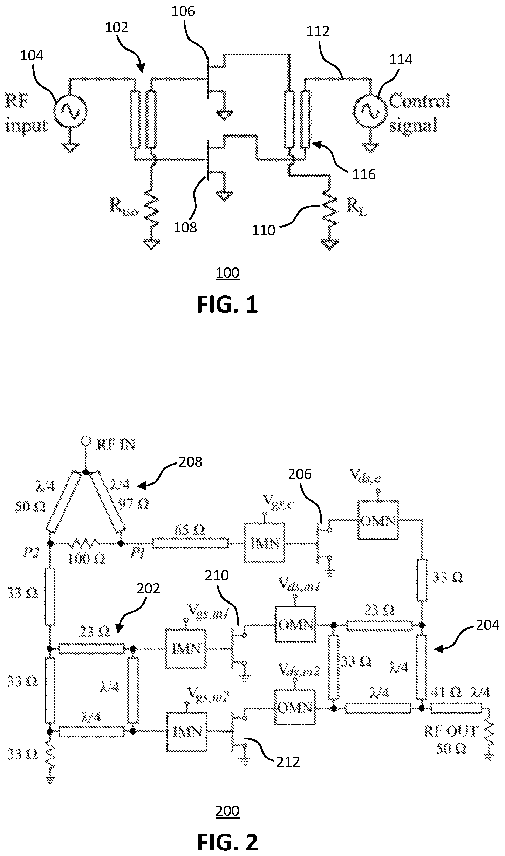

A circuit diagram of an example of a LMBA 100 with field coupled line hybrids is shown in Figure 1. The hybrid 102 on the input side splits the RF input signal 104 into two signals with 90 degrees phase difference at the gates of transistors 106 and 108. This makes the transistor output signals interfere constructively at the output port of the output hybrid, connected to the load resistance 110, and destructively at the control signal port 112. This is similar to a traditional balanced amplifier.

Where the traditional BA has a resistive termination, the LMBA 100 has a control signal input 112. The amplifier 114 that provides the control signal is called the control amplifier (CA). The control signal passes through the output hybrid coupler 116 to the load 110 by splitting in the hybrid 116, reflecting off the transistors 106 and 108 in the BA, and recombining in the hybrid 116. Since the control signal reflects off the transistors 106 and 108, it causes an additional voltage swing at the outputs of the BA transistors that makes their effective load resistances change. This is called load modulation. Since the 3-dB hybrid coupler 116 splits the control signal in two equal parts, the load modulation is equal at the two BA transistors 106 and 108.

A circuit diagram of a more detailed example of a LMBA 200 is shown in Figure 2, with branchline type 3-dB hybrids, control amplifier 206, RF input signal split 208, and input and output matching networks (input matching network, IMN, and output matching network, OMN) for all transistors 206, 210 and 212.

In prior art there are two variants of the LMBAs 100 or 200, distinguished by the order in LMBA output amplitude in which the amplifier parts (balanced amplifier and control amplifier) are used. In the first variant [1] the control amplifier (CA) is used alone in a first mode at amplitudes below the transition point. In the second variant [2] the BA is used alone in a first mode below the transition point. In both variants, the BA and CA are used together in their second mode above the transition point, but the two variants' second modes entail different behaviors of the amplifier parts, as explained further below. The upper ends of both modes, i.e. the transition point and the full output amplitude point, both correspond to a maximum in the efficiency curve.

The transition point amplitude determines the relative maximum output powers of the transistors in the BA and CA. For a transition point at low amplitude, the first variant has a small CA and a large BA. The second variant instead has a smaller BA and a larger CA. This difference is also reflected in different impedance or voltage swing levels in different parts of the system and can thus also be seen in transformation ratios and/or supply voltage ratios.

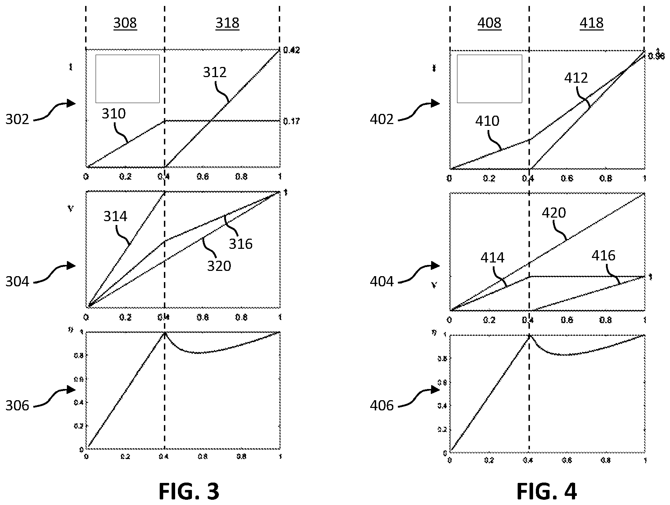

The operation of the first variant of the LMBA 100 or 200 is shown in Figure 3. This shows a graph of output currents 302, output voltages 304 and efficiency 306 of the LMBA and the BA and CA parts. Normalized LMBA output amplitude is shown on the horizontal axis. The LMBA 100 and 200 may in some examples be considered as a substantially fixed gain amplifier whereby the output gain is controlled by controlling the level of the input signals. In a first mode 308, for a normalized LMBA output amplitude of between 0 and around 0.4, the input signal to the control amplifier is controlled such that the output current 310 rises in a linear manner to around 0.17A in this example, and the input signal to the balanced amplifier remains at substantially zero, such that the current output 312 of the BA remains at substantially zero. The resulting (normalized) output voltages 314 and 316 respectively of the CA and BA are also shown. In the second mode 318, the input signals are controlled such that the current output 310 of the CA remains constant (in this example at around 0.17A) and the current output 312 of the BA rises in a linear manner from zero to around 0.42A in this example. The overall voltage output 320 from the LMBA is approximately linear across the output range. It can be seen from the (normalized) efficiency graph 306 that there is an efficiency maximum at the upper end of both modes, that is around 0.4 and 1 of the normalized output amplitude.

The operation of the second variant of the LMBA 100 or 200 is shown in Figure 4. This shows a graph of output currents 402, output voltages 404 and efficiency 406 of the LMBA and the BA and CA parts. Normalized LMBA output amplitude is shown on the horizontal axis. The LMBA 100 and 200 may in some examples be considered as a substantially fixed gain amplifier whereby the output gain is controlled by controlling the level of the input signals. In a first mode 408, for a normalized LMBA output amplitude of between 0 and around 0.4, the input signal to the BA is controlled such that the output current 410 rises in a linear manner to around 0.2A in this example, and the input signal to the CA is controlled such that the current output 412 of the CA remains at substantially zero. The resulting (normalized) output voltages 414 and 416 respectively of the CA and BA are also shown. In the second mode 418, the input signals are controlled such that the current output 410 of the BA rises in a linear fashion to around 0.96A in this example, and the current output 412 of the CA rises in a linear manner from zero to around 1A in this example. The overall voltage output 420 from the LMBA is approximately linear across the output range. It can be seen from the (normalized) efficiency graph 406 that there is an efficiency maximum at the upper end of both modes, that is around 0.4 and 1 of the normalized output amplitude

It can be seen that for both variants, the first variant illustrated in Figure 3 and the second variant illustrated in Figure 4, the first modes are similar in behavior with a single amplifier part (CA or BA) operating alone up to the transition point, at which its voltage swing is at maximum amplitude. The second modes are however different between the variants. The first variant's CA current is at constant amplitude in the second mode, while the second variant's BA currents increase even more with increasing amplitude in the second mode. The two LMBA variants (or the two variants of LMBA operation) may have the same supply voltage to all transistors. In an example implementations the first variant may have an impedance transformation down of 6 times from the CA to the BA, and the second variant may have a transformation up of 4 times from the CA to the BA. The normalized efficiency curves are similar for both cases, but the voltage and current curve shapes and the relative maximum output powers differ. Prior art solutions US2002/171477A1 and US2005/134377 A1 fail to disclose the method of operation, or of configuration to operate amplifiers as in the present solution.

### Summary

The invention is set out in the appended set of claims.

### Brief Description of the Drawings

For a better understanding of examples of the present disclosure, and to show more clearly how the examples may be carried into effect, reference will now be made, by way of example only, to the following drawings in which:
Figure 1 is a circuit diagram of an example of a load modulated balanced amplifier (LMBA);
Figure 2 is a circuit diagram of a more detailed example of a LMBA;
Figure 3 shows graphs of signals in a first variant of operation of a LMBA;
Figure 4 shows graphs of signals in a second variant of operation of a LMBA;
Figure 5 is an example of an amplifier circuit;
Figure 6 shows an example of a two-stage amplifier circuit;
Figure 7 is a flow chart of an example of a method of operating an amplifier circuit;
Figure 8 is a graph showing an example of signals in an amplifier circuit during operation;
Figure 9 shows another example of a two-stage amplifier circuit;
Figure 10 is a flow chart of another example of a method of operating an amplifier circuit;
Figure 11 is a graph showing another example of signals in an amplifier circuit during operation;
Figure 12 is a graph showing another example of signals in an amplifier circuit during operation; and
Figure 13 is another example of an amplifier circuit.

### Detailed Description

The following sets forth specific details, such as particular embodiments or examples for purposes of explanation and not limitation. It will be appreciated by one skilled in the art that other examples may be employed apart from these specific details. In some instances, detailed descriptions of well-known methods, nodes, interfaces, circuits, and devices are omitted so as not obscure the description with unnecessary detail. Those skilled in the art will appreciate that the functions described may be implemented in one or more nodes using hardware circuitry (e.g., analog and/or discrete logic gates interconnected to perform a specialized function, ASICs, PLAs, etc.) and/or using software programs and data in conjunction with one or more digital microprocessors or general purpose computers. Nodes that communicate using the air interface also have suitable radio communications circuitry. Moreover, where appropriate the technology can additionally be considered to be embodied entirely within any form of computer-readable memory, such as solid-state memory, magnetic disk, or optical disk containing an appropriate set of computer instructions that would cause a processor to carry out the techniques described herein.

Hardware implementation may include or encompass, without limitation, digital signal processor (DSP) hardware, a reduced instruction set processor, hardware (e.g., digital or analogue) circuitry including but not limited to application specific integrated circuit(s) (ASIC) and/or field programmable gate array(s) (FPGA(s)), and (where appropriate) state machines capable of performing such functions.

With prior art amplifiers, such as for example LMBAs such as the LMBAs 100 and 200 described above, and also other amplifier types such as Doherty and Chireix types, there is only one extra efficiency maximum per added stage, i.e. the number of efficiency maxima grows only linearly with the number of stages. This means that a lot of stages are needed to get high efficiency in a wide amplitude range. For an efficiency maximum at low amplitude, the impedance ratio or voltage swing ratio between different parts of the prior art amplifiers (including LMBAs, Doherty and Chireix amplifiers) is large. For example, placing the efficiency maximum at 0.25 of full amplitude, i.e. at -12 dB, requires an impedance ratio of 12.5 times for the first variant of a LMBA [1], and 18 times for the second variant [2], if all transistors have the same supply voltage. A large impedance transformation ratio between different points in the system means that the impedance transformers are longer and more lossy. It also means that reverse waves from reflections, antenna-to-antenna leakage or external interferers are potentially transformed to very high voltage levels which can lead to breakdown and other problems such as distortion and loss of output power.

Examples of this disclosure include amplifier circuits and methods of operating amplifier circuits. Herein an amplifier circuit means a circuit that could itself be an amplifier or be used as an amplifier, but may contain one or more other amplifiers, amplifier circuits and/or amplifier stages. The terms amplifier and amplifier circuit may in some examples be interchangeable.

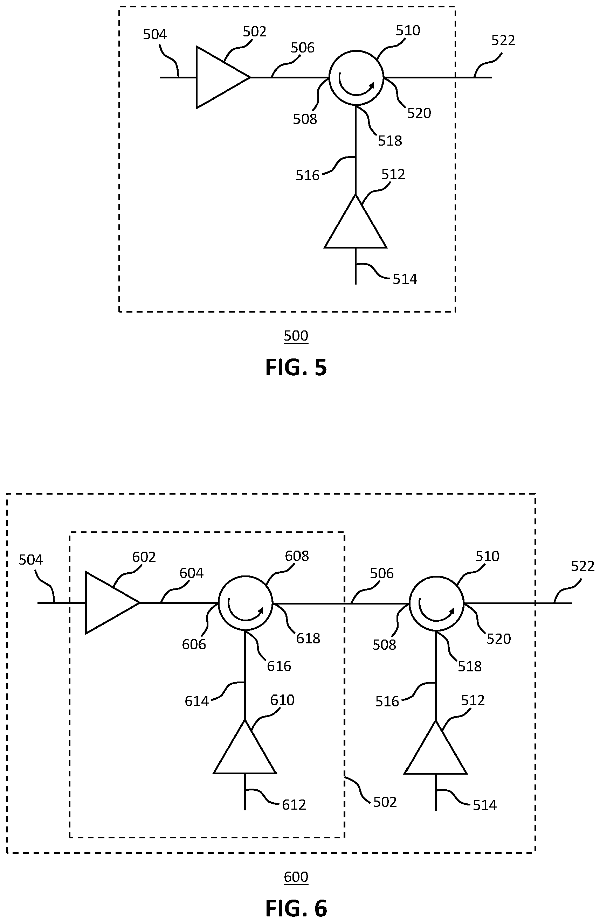

Figure 5 is an example of an amplifier circuit 500 according to an example of this disclosure. In some examples, methods of operating an amplifier circuit as disclosed herein and as described below may be performed on the amplifier circuit 500. The amplifier circuit 500 comprises a first amplifier 502 configured to receive a first signal 504, and to provide a first amplified signal 506 to a first port 508 of a first circulator 510. A second amplifier 512 is configured to receive a second signal 514 and to provide a second amplified signal 516 to a second port 518 of the first circulator 510. A third port 520 of the first circulator 510 comprises an output 522 of the amplifier circuit 500.

In use, the first signal 504 and second signal 514 may be based on a signal to be amplified. For example, the first and second signals 504 and 514 may be scaled versions of the signal to be amplified, where the first and second signals 504 and 514 are scaled by respective amounts, which may be independently controlled or different in some examples. Additionally or alternatively, in some examples, one or both of the first and second signals 504 and 514 may be inverted compared to the signal to be amplified. The signal 516 from the second amplifier 512 enters the second port 518 of the first circulator 510 and exits the circulator 510 at the third port 520 which is connected to the output 522.

Similarly, the signal 506 from the first amplifier 502 exits the first circulator 510 at the second port 518. This signal may reflect at the output of the second amplifier 512 and back towards the second port 518 of the circulator 510. This reflected signal then exits the same port (the third port 520) of the circulator 510 as the signal from the second amplifier 512 itself and thus also goes to the output 522.

When the signal from the first amplifier 502 reflects off the second amplifier 512 it may add a voltage to the second amplifier's voltage. When this voltage is in phase with that from the second amplifier 512 at the output node of the second amplifier 512, the current from the second amplifier 512 may be lower to achieve to full voltage swing than if the second amplifier 512 was working alone. Thus in some examples, components in the amplifier circuit 500 may be selected or tuned to achieve in-phase signals at the output node of the second amplifier 512 in this manner. If instead the voltage is in antiphase with that of the second amplifier 512, the current may need to be larger to get to full voltage swing than if the second amplifier 512 was working alone. In some examples, the reflection referred to above ultimately is in the high impedance of the transistor output node, such that the voltage is doubled compared with the traveling wave voltage.

In some examples, potential efficiency maxima for the amplifier circuit 500 may occur when all active amplifiers (e.g. the first and second amplifiers 502 and 512 in this example) have maximum voltage swing at their output nodes. This is because at maximum voltage swing, the voltage over transistors in the amplifiers may be minimal during the time of current pulse injection. In an example, efficiency maxima for the amplifier circuit 500 may occur at four different output amplitude levels: 1) when the first amplifier 502 is operating at full voltage swing and the second amplifier 512 provides zero output, 2) when the second amplifier 512 is active and adds its own voltage on top of that coming from the first amplifier 502, itself operating at full voltage swing, 3) when the second amplifier 512 is operating alone (the first amplifier 502 has zero output) at full voltage swing, and 4) when the first amplifier 502 is operating at full output swing but in antiphase with the second amplifier 512, and the second amplifier 512 uses even more current to achieve full voltage swing. In the last case, the input signals to the respective amplifiers may for example based on the signal to be amplified and in antiphase.

The first circulator 510 is configured to provide the first amplified signal 506 provided to the first port 508 of the first circulator 510 from the second port 518 of the first circulator. Thus for example this signal is provided to the output node of the second 512 and may reflect from that node. In some examples, the first circulator 510 is configured to provide the second amplified signal 516 provided to the second port 518 of the first circulator 510 from the third port 520 of the first circulator. The reflected signal reflected from the output node of the second amplifier 512 may also thus be provided to the third port 520 in some examples.

In some examples, the amplifier circuit 500 comprises an impedance transformer (not shown) in a signal path of the first amplified signal 506 between the first amplifier 502 and the first port 508 of the first circulator 510. Additionally or alternatively, in some examples, the amplifier circuit 500 comprises an impedance transformer in a signal path of the second amplified signal 514 between the second amplifier 512 and the second port 518 of the first circulator 510.

As compared to the LBMA shown in Figure 1 or 2 for example, in some examples, there may be the same maximum output power in the first amplifier 502 as the total output power from the two hybrid-coupled amplifiers (e.g. transistors 106 and 108 shown in Figure 1) to achieve similar overall output power from the amplifier circuit 500 as from the LMBA. If the signal path of the first amplified signal 506 includes an impedance transformer, this may the lack of a hybrid (e.g. hybrid 116 shown in Figure 1) into account. A hybrid generally splits a signal at an input port of a certain impedance into equal amplitude signals at two ports with that same impedance. This means that it may transform the impedance down by a factor of two, from the port where an amplified signal enters (e.g. from amplifier 114 shown in Figure 1) , to the two balanced amplifiers which in examples shown in Figure 5 may be considered as replaced by the single second amplifier 512. Thus, for example, if the transformation (not shown in Figure 1 but which may be present in some examples) between the amplifier (e.g. amplifier 114) and each of the two balanced amplifiers (e.g. transistors 106 and 108) in an LMBA implementation is down by a factor X, the transformation between the first and second amplifiers 502 and 512 in the amplifier circuit 500 (e.g. in the signal path of the first amplified signal 504) may be down by a factor 2X. If for example the transformation in the LMBA is instead up by a factor X, the transformation in the amplifier circuit 500 may be up by a factor X/2.

In some examples, the amplifier circuit 500 is a two-stage amplifier. Thus, for example, the first amplifier 502 may itself be an amplifier circuit that is similar or identical to the amplifier circuit 500 shown in Figure 5. Figure 6 shows an example of a two-stage amplifier circuit 600 according to an example of this disclosure. Components that are the same as or similar to those in Figure 5 are given the same reference numerals. In the amplifier circuit 600, however, first amplifier 502 is an amplifier circuit that comprises a third amplifier 602 configured to receive the first signal 504 and to provide a third amplified signal 604 to a first port 606 of a second circulator 608. A fourth amplifier 610 configured to receive a fourth signal 612 based on a signal to be amplified (e.g. scaled and/or inverted from the signal to be amplified) and to provide a fourth amplified signal 614 to a second port 616 of the second circulator 608. A third port 618 of the second circulator 608 is connected to the first port 508 of the first circulator 510, thus to provide the first amplified signal 506 (which is provided by the third port 618 of the second circulator 608) to the first port 508 of the first circulator 510. In some examples, there may be an impedance transformer in a signal path between the third port of the second circulator and the first port of the first circulator. Additionally or alternatively, there may be an impedance transformer in the signal path of the third amplified signal 604 and/or fourth amplified signal 614.

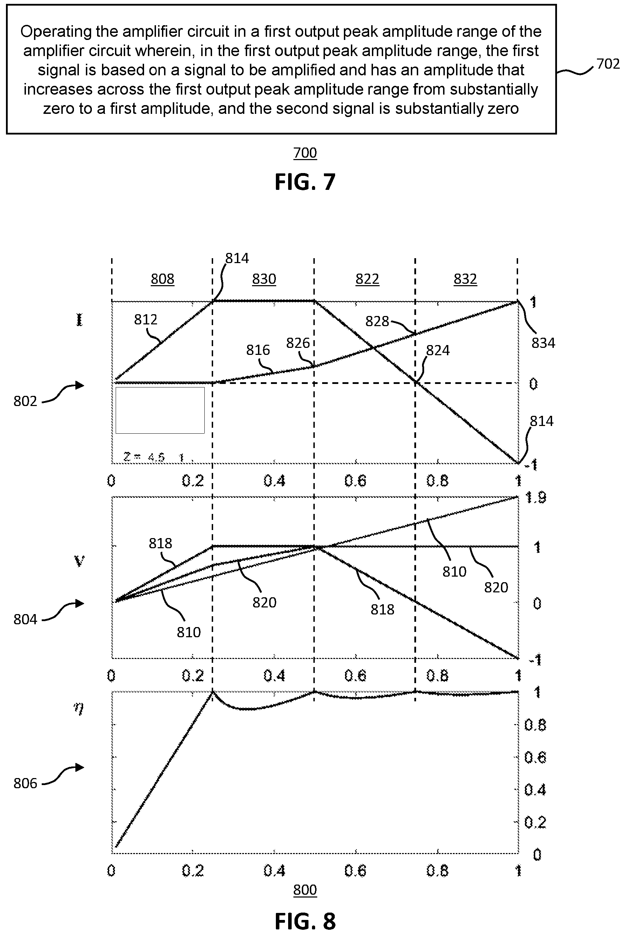

Figure 7 is a flow chart of an example of a method 700 of operating an amplifier circuit, such as for example the amplifier or amplifier circuit 500 or 600 described above. Step 702 of the method comprises operating the amplifier circuit in a first output peak amplitude range of the amplifier circuit wherein, in the first output peak amplitude range, the first signal is based on a signal to be amplified and has an amplitude that increases across the first output peak amplitude range from substantially zero to a first amplitude, and the second signal is substantially zero.

Figure 8 is a graph showing an example of signals in the amplifier circuit 500 or 600 during operation in accordance with some examples of the method 700. In particular, the signals and graphs shown include currents 802, voltages 804 and efficiency 806 in the amplifier circuit. In the first output peak amplitude range 808 (as shown by amplifier circuit output voltage 810), the first signal 504 (as shown by current signal 812) has an amplitude that increases across the first output peak amplitude range from substantially zero to a first amplitude 814. The first signal 812 is also based on an amplifier input signal. That is, for example, the amplifier input signal is a signal to be amplified and be provided as the amplified output signal 524, and the first signal 812 may be an amplified, scaled or otherwise manipulated version of the amplifier input signal. In some examples, the amplifier input signal may be produced from a digital signal, e.g. may be provided from a digital to analogue converter (DAC). In the first output peak amplitude range 808, the second signal 514 (as shown by current signal 816) is substantially zero. Voltage output from the first amplifier 502 is shown as voltage signal 818, and voltage output from the second amplifier 506 is shown as voltage signal 820.

In some examples, the method 700 includes operating the amplifier circuit 500 or 600 in a second output peak amplitude range 822 of the amplifier circuit 500, wherein the second output peak amplitude range is higher than the first output peak amplitude range and wherein, in the second output peak amplitude range 822, the first signal 504 is based on the signal to be amplified and has an amplitude that decreases across the second output peak amplitude range from the first amplitude 814 to a second amplitude 824 (which in this example is zero), and the second signal 514 is based on the signal to be amplified and has an amplitude that increases across the second output peak amplitude range 822 from a third amplitude 826 to a fourth amplitude 828. The second output peak amplitude range is shown in Figure 8 as range 822, and the corresponding current and voltage signals in the amplifier circuit 500 or 600 can be seen. This may for example remove the voltage swing contribution by the first amplifier at the second amplifier, which may give more room for the voltage caused by the second amplifier's own current. This means for example that the second amplifier can ramp up its current until it provides all output power by itself, which in a particular example is 9W.

As shown by the efficiency graph 806, there is an efficiency maximum at the upper end of both the first and second ranges 808 and 822. Figure 8 shows other ranges 830 and 832, though in some examples the ranges 830 and/or 832 are not present. In cases where range 830 is not present, the first and second ranges 808 and 822 may be contiguous, and the third amplitude 826 may be substantially zero.

In some examples, the method 700 may further comprise operating the amplifier circuit in a third output peak amplitude range 832 of the amplifier circuit 500 or 600, wherein the third output peak amplitude range is higher than the second output peak amplitude range 822 and wherein, in the third output peak amplitude range 832, the first signal 504 is based on the signal to be amplified and has an amplitude that increases across the third output peak amplitude range 832 from substantially zero to the first amplitude 814 and is of opposite phase to the first signal in the first output peak amplitude range. In effect, this means that the first signal 504 in the third range 832 is effectively a "negative" or 180-degrees phase shifted signal as compared to the first signal 504 in the first range 808. Also, in the third range 832, the second signal 514 is based on the signal to be amplified and has an amplitude that increases across the third output peak amplitude range 832 from the fourth amplitude 828 to a fifth amplitude 834. As a result, for example, in a particular implementation, the first amplifier may provide a RF-wise negative voltage at the output node of the second amplifier 512, which may increase headroom for the voltages caused by their own output currents. Even with a very small first amplifier 502 power of 1W, for example, the second amplifier 514 can keep ramping up so that the total amplifier circuit may in a particular example reach 16W, well beyond the e.g. 9W of the second amplifier 512 by itself.

It can be seen that the efficiency 806 of the amplifier circuit demonstrates an additional maximum at the upper end of the third range 832. In fact, in examples of this disclosure all the upper ends of all the amplitude ranges may provide efficiency maxima. This may be because for example at these points the RF voltage swing is maximal at the outputs of the amplifiers that provide an RF output current. When the voltage swing is maximal, the average voltage over the transistors may instead be minimal during the time current pulses are injected. This may result in minimum loss and hence maximum efficiency. At the upper end of the first range 808 shown in Figure 8 the first amplifier may in some examples fulfil this condition. At the upper end of the first auxiliary range 830 (described below) it is both the first amplifier and the second amplifier, with voltage contributions in the same phase at the second amplifier transistors in a particular example implementation. At the upper end of the second range 822 it is only the second amplifier that is at maximum voltage swing, but also only the second amplifier delivers current. At the upper end of the third range 832 both the first amplifier and the second amplifier have full voltage swing and deliver current, but here the first amplifier voltage is in antiphase with the second amplifier's voltage contribution at for example the transistors of the second amplifier.

In some examples, the method 600 may further comprise operating the amplifier circuit in a first auxiliary output peak amplitude range 830 of the amplifier circuit 500 or 600, wherein the first auxiliary output peak amplitude range 830 is higher than the first output peak amplitude range 808 and lower than the second output peak amplitude range 822 and wherein, in the first auxiliary output peak amplitude range 830, the first signal 504 is based on the signal to be amplified and has the first amplitude 814 (i.e. is substantially constant across this range). Also, in this range 830, the second signal 514 is based on the signal to be amplified and has an amplitude that increases across the first auxiliary output peak amplitude range 830 from substantially zero to the third amplitude 826.

In some particular examples, a rate of increase of the second signal 514 across the second output peak amplitude range 822 from the third amplitude 826 to the fourth amplitude 828 may be higher than a rate of increase of the second signal 514 across the first auxiliary output peak amplitude range 830 from substantially zero to the third amplitude 826. Additionally or alternatively, a rate of increase of the second signal 514 across the third output peak amplitude range 832 from the fourth amplitude 828 to the fifth amplitude 834 is higher than a rate of increase of the second signal across the first auxiliary output peak amplitude range from substantially zero to the third amplitude 826. This can be seen in Figure 8 as the current signal 816 has a steeper slope in the ranges 822 and 832 than in the range 830. This may be for example to compensate for the decreasing first signal 504 input to the first amplifier 502 (represented by current signal 812).

In some examples, the first amplifier may be sufficiently linear for small signals, since it operates alone at low output peak amplitudes of the amplifier circuit (e.g. in the first range 808) and also its output passes through zero between ranges 822 and 832. Thus in some examples the first amplifier may be implemented as a class B or AB amplifier (e.g. through choice of gate bias voltage). In some examples, the drive signal to the first amplifier (the first signal) may also need to provide a phase inversion between ranges 822 and 832. The second amplifier 512 has zero output at low amplitudes, such as for example in the first range 808, and so it may be biased in class C for higher efficiency.

In a variant example, a balanced amplifier (BA) may be used as the first amplifier 502. This may provide for example the benefit of low output reflection of traditional terminated BA operation.

For dimensioning, in some examples, a single parameter k may be used, which is the square root of the ratio of the first amplifier 502's maximum output power, P₁, to the maximum total output power, P_{TOT}. This dimensionless parameter determines the relative amplitude distance between efficiency maxima. For a choice of k less than 1/3, there may be four efficiency maxima, found at relative output amplitudes k, 1 - 2k, 1 - k, and 1 (where 1 represents full output magnitude for example). These efficiency maxima correspond to the different combinations of outputs from the first and second amplifiers 502 and 512 described above. The maximum output power of the second amplifier 512 may be represented by P₂.

For k exactly 1/4, there are four equally spaced maxima, at 0.25, 0.5, 0.75, and 1 of full output amplitude. For k exactly 1/3, the two lowest maxima are both at 1/3 so the distance between them is zero. This is due to the voltage from the second amplifier 512 tracking that of the first amplifier 502 exactly, so that they both reach their maximum at the same amplitude point. Hence, there may be three equally spaced maxima in this case. The power relations are given by for example: ${P}_{TOT} = {P}_{1} + {P}_{2}$ ${P}_{1} = {k}^{2} * {P}_{TOT}$ ${P}_{2} = \left(1-{k}^{2}\right) * {P}_{TOT}$

As an example of k=1/4 dimensioning, in an example, P_{TOT} = 16 W and P₁ = 1 W. The second amplifier 512's maximum output power P₂ is then 15 W. There may be four modes over four equally wide amplitude ranges, 0 - 0.25, 0.25 - 0.5, 0.5 - 0.75, and 0.75 - 1 of full output amplitude for the amplifier circuit 500 or 600. The top end of each range constitutes a maximum in the efficiency curve, i.e. the four efficiency maxima get evenly distributed in amplitude, at 0.25, 0.5, 0.75 and 1 of full amplitude.

As an example of k=1/3 dimensioning, in an example, P_{TOT} = 1800 W and P₁ = 200 W. The second amplifier 512's maximum output power P₂ is then 1600 W. There may be three modes over three equally wide amplitude ranges, 0 - 0.33, 0.33 - 0.67, and 0.67 - 1 of full amplitude, with a maximum in the efficiency curve at the top end of each range.

The impedance level at the output of the second amplifier 512 may in some examples be chosen so that the second amplifier 512 has full voltage swing when it by itself is outputting a power corresponding to the next to highest efficiency maximum. Since this is at an amplitude level of 1-k of full output amplitude, this output power is (1-k)² of the full output power (in this example 9 W out of 16 W). In the case of equal supply voltages to both amplifiers, the transformation is given by the relation k²/(1-k)², i.e. the relation between the maximum output of the first amplifier 502 alone to that of the second amplifier 512 alone. For the example with k = 1/4 there may then be a transformation down by 9 from the output node of the first amplifier 502 to the output node of the second amplifier 512, i.e. the load impedance of the second amplifier 512 at its transistor output node when driven alone is 1/9 of that of the first amplifier 502. For k = 1/3, the second amplifier 512's load impedance should be 1/4 of that of the first amplifier 502, and the transformation may be down by 4 times.

Another variant in some examples is to use the transformation ratios and impedance levels of one or more examples described above but operate only up to the amplitude where the second amplifier 512 operates alone, e.g. the upper end of the second output peak amplitude range 822 shown in Figure 8. This may give the advantage of having the same relative load impedance at the second amplifier 512 as at the first amplifier 502, which means that the second amplifier 512's properties, for example bandwidth, may be as good as those for the first amplifier 512. The drawbacks may be that the first amplifier 502 is not utilized at maximum power, and that there is one less efficiency maximum. The second amplifier 512 will need to output all the maximum power of the amplifier circuit 500 or 600 by itself, which with three equally distributed efficiency maxima is 9 times that of the first amplifier 502, while the first amplifier 502 does not contribute.

In some examples, the same parameter(s) for k can be used as suggested above, but only the efficiency maxima at 1-k, e.g. where the second amplifier 512 operates alone, and 1 of full output amplitude are used. The signal from the first amplifier 502 may be in antiphase with the second amplifier 512 at the output node of the second amplifier 512 at all output amplitudes of the amplifier circuit 500 or 600. To place the lower amplitude maximum lower in amplifier circuit output amplitude, a larger k needs to be used, and hence more equally sized first and second amplifiers 502 and 512 may be used as compared to some examples described above. With equal supply voltages to both amplifiers, in some examples, any impedance transformation from the first amplifier to the second amplifier may be larger for efficiency maxima below 0.5 of full amplitude. A smaller second amplifier 512 and a corresponding larger up-transformation may place the efficiency maximum at a lower amplitude. For example, to place a lower efficiency maximum at 0.25 (-12 dB) of full amplifier circuit output amplitude, the transformation may for example be up by a factor of 9 between the first and second amplifiers 502 and 512 (transistor output node to transistor output node) when equal supply voltages are used. The size (maximum output power) of the second amplifier 512 may be for example 0.78 times that of the first amplifier 502.

To place the lower efficiency maximum at 0.4 of full amplitude, for example, the transformation may be up by a factor of 2.25 between the first and second amplifiers when equal supply voltages are used. The size of the second amplifier 512 may be for example 1.78 times that of the first amplifier 502. To place the lower efficiency maximum at 0.5 of full amplitude, for example, no transformation may be needed between the amplifiers 502 and 512 with equal supply voltages, and the size of the second amplifier 512 may be for example 3 times that of the first amplifier 502.

The method 700 comprise generating the first and second signals based on the signal to be amplified. This may comprise generating the first signal based on the first signal scaled by a first factor, and generating the second signal based on the second signal scaled by a second factor. The first and second factors may in some examples take the same form as the signals 812 and 816 corresponding to the first and second signals respectively shown in Figure 8. Thus, for example, the operating the amplifier circuit in the first output peak amplitude range 808 of the amplifier circuit may comprise, in the first output peak amplitude range 808, increasing the first factor across the first output peak amplitude range 808 from substantially zero to a first value, wherein the second factor is substantially zero. Similarly, for example, operating the amplifier circuit in the second output peak amplitude range 822 of the amplifier circuit may comprise, in the second output peak amplitude range 822, decreasing the first factor across the second output peak amplitude range 822 from the first value to a second value, and increasing the second factor across the second output peak amplitude range 822 from a third value to a fourth value.

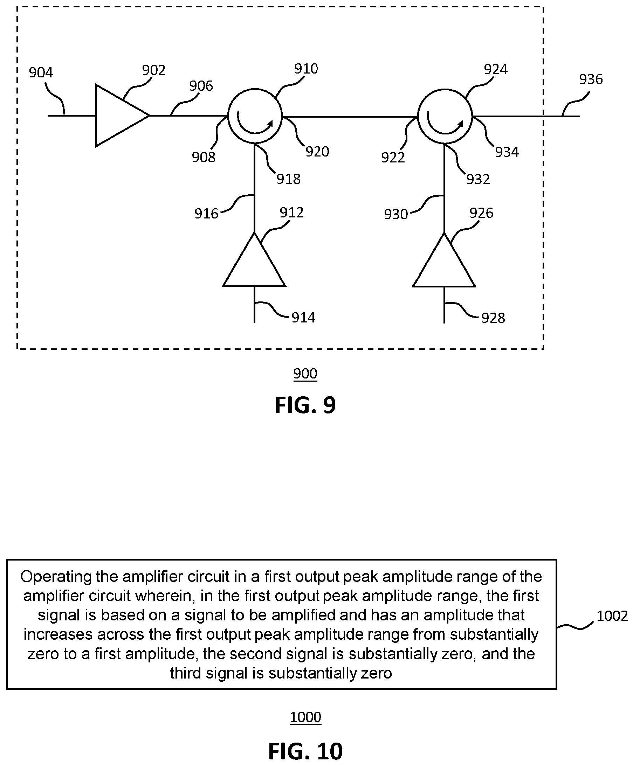

Figure 9 shows an example of a two-stage amplifier circuit 900. The amplifier circuit 900 may be similar to the amplifier circuit 600 shown in Figure 6 in some examples. The amplifier circuit 900 includes a first amplifier 902 (e.g. similar to the third amplifier 602) configured to receive a first signal 904 (e.g. similar to the first signal 504) and to provide a first amplified signal 906 to a first port 908 of a first circulator 910 (e.g. similar to the second circulator 608). A second amplifier 912 (e.g. similar to the fourth amplifier 610) is configured to receive a second signal 914 (e.g. similar to the third signal 612) and to provide a second amplified signal 916 to a second port 918 of the first circulator 910. A third port 920 of the first circulator 910 is connected to a first port 922 of a second circulator 924 (e.g. similar to the first circulator 510). The amplifier circuit 900 further comprises a third amplifier 926 (e.g. similar to the second amplifier 512) configured to receive a third signal 928 (e.g. similar to the second signal 514) and to provide a third amplified signal 930 to a second port 932 of the second circulator 924. A third port 934 of the second circulator 924 comprises an output 936 of the amplifier circuit 900.

In some examples of two-stage amplifier circuits, such as those shown in Figures 6 and 9, the combination of the amplifiers connected to the circulator 608 or 910 may produce output power up to the maximum with potentially four modes, each with an efficiency maximum at its top amplitude. This mode pattern (and also in other examples with fewer efficiency maxima) will produce efficiency maxima together with the additional amplifier 512 or 926 in all combinations where the combination of amplifiers connected to circulator 608 or 910 is at maximum efficiency, and where either the voltage amplitude at the additional amplifier 608 or 910 is at maximum or does not deliver current.

A new parameter k₂ can be defined as the square root of the ratio of the maximum output power of the combination of amplifiers connected to the circulator 608 or 910 to the total maximum output power of the amplifier circuit 600 or 900. As earlier, the first amplifier stage (including the amplifiers connected to the circulator 608 or 910) can be used in a ramping up mode (0 to k₂ relative output amplitude) by itself, a ramping down mode (1-2k₂ to 1-k₂) where the additional amplifier 512 or 926 increases its output until it operates alone, and a ramping up in antiphase mode (1-k₂ to 1 relative output amplitude) where the additional amplifier 512 or 926 increases its output even more. Each of these modes may have up to four efficiency maxima. With an additional mode in some examples from k₂ to 1-2k₂ where the additional amplifier 512 or 926 increases output while the output for amplifiers connected to the circulator 608 or 910 remains constant, the total number of possible modes and efficiency maxima may be up to 13 in some examples.

For evenly spaced efficiency maxima, the total output power may be for example 13² = 169 times the output power of the amplifier 602 or 902 (which may define the lowest efficiency maximum). The amplifier 610 or 912 may be for example 15 times larger than the amplifier 602 or 902, and the additional amplifier 512 or 926 may need to be for example 169-16 = 153 times the output of the amplifier 602 or 902. The parameter k₂ may be for example the square root of 16/169, i.e. 4/13.

Any transformation ratios between the stages for equal supply voltages may in some examples be defined by the output powers of the different amplifiers at the respective efficiency maxima where they are operating alone. For the amplifier 602 or 902, for example, this is the full output power P₁. For amplifier 610 or 912, it is the output power at the third efficiency maximum at 1-k for the amplifiers connected to the circulator 608 or 910 (9 times P₁ for 4 evenly spaced efficiency maxima). For the additional amplifier 512 or 926, it is the output power at the ninth efficiency maximum at 1-k₂ for the combination of all three amplifiers, i.e. at (1-4/13)₂*13₂ = 81 times P₁. Any transformation between the last two stages (e.g. between amplifiers 912 and 926, or between amplifiers 610 and 512) may be the same in some examples, down a factor of 9, as the transformation between the first two stages (e.g. between amplifiers 902 and 912, or between amplifiers 602 and 610).

By adding a fourth stage (referred to as A4) there may be for example up to 40 evenly spaced efficiency maxima, and the total output power may then be for example 40² = 1600 times P₁. The maximum output power of A4 may be for example 1600-169 = 1431 times P₁. The output power of A4 when operating alone may for example be (1-13/40)²*40² = 729 times P₁ which is another factor of 9 higher in power. Therefore, a transformation down by 9 may be used in some examples between the stages if equal supply voltages are used. This may be a general rule for maximal numbers of evenly spaced efficiency maxima and equal supply voltages in some examples, whereby the transformation between two following stages is down by a factor of 9.

Figure 10 is a flow chart of another example of a method 1000 of operating an amplifier circuit, such as for example the amplifier circuit 600 shown in Figure 6, or the amplifier circuit 900 shown in Figure 9 (i.e. a two-stage amplifier). The method 1000 is described using terminology relating to Figure 9, though the method 1000 may also be applied according to similar components shown in Figure 6. The method 1000 comprises, in step 1002, operating the amplifier circuit 900 in a first output peak amplitude range of the amplifier circuit 900 wherein, in the first output peak amplitude range, the first signal 904 is based on a signal to be amplified and has an amplitude that increases across the first output peak amplitude range from substantially zero to a first amplitude, the second signal 914 is substantially zero, and the third signal 928 is substantially zero.

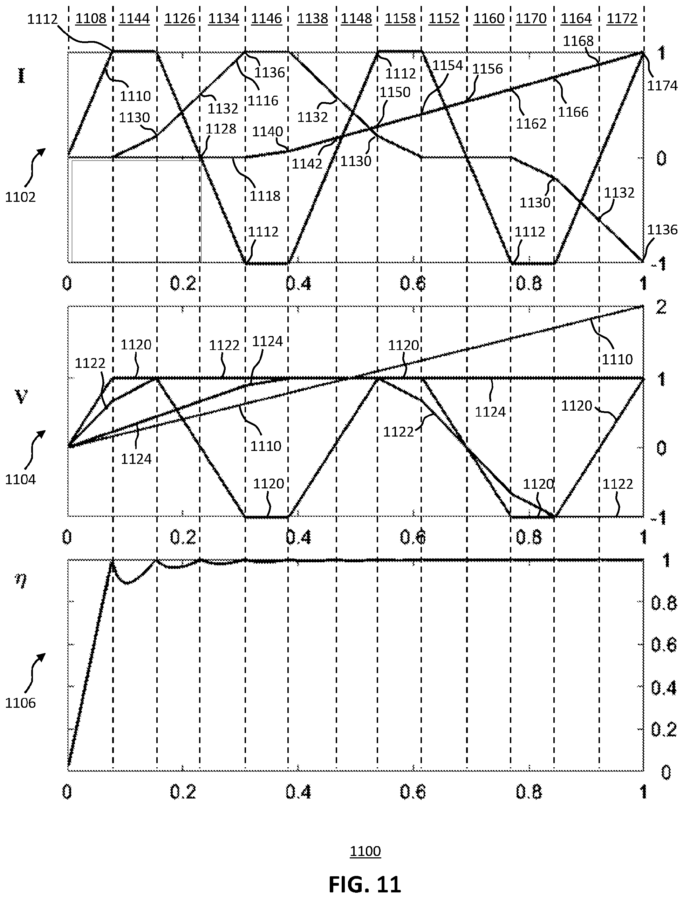

Figure 11 is a graph showing an example of signals in the amplifier circuit 900 (or 600) during operation in accordance with the method 1000. In particular, the signals and graphs shown include currents 1102, voltages 1104 and efficiency 1106 in the amplifier circuit. In the first output peak amplitude range 1108 (as shown by amplifier circuit output voltage 1110), the first signal 904 (as shown by current signal 1112) has an amplitude that increases across the first output peak amplitude range from substantially zero to a first amplitude 1114. The first signal 1112 is also based on an amplifier input signal. That is, for example, the amplifier input signal is a signal to be amplified and be provided as the amplified output signal 946, and the first signal 1112 may be an amplified, scaled or otherwise manipulated version of the amplifier input signal. In some examples, the amplifier input signal may be produced from a digital signal, e.g. may be provided from a digital to analogue converter (DAC). In the first output peak amplitude range 1108, the second signal 914 (as shown by current signal 1116) is substantially zero, and the third signal 928 (as shown by current signal 1118)is substantially zero. Voltage output from the first amplifier 902 is shown as voltage signal 1120, and voltage output from the first amplifier 902 is shown as voltage signal 1122. Voltage output from the second amplifier 912 is shown as voltage signal 1124.

In some examples, the method 1000 comprises operating the amplifier circuit in a second output peak amplitude range 1126 of the amplifier circuit, wherein the second output peak amplitude range 1126 is higher than the first output peak amplitude range 1108. In the second output peak amplitude range 1126, the first signal 904 is based on the signal to be amplified and has an amplitude that decreases across the second output peak amplitude range 1126 from the first amplitude 1112 to a second amplitude 1128 (which in this example is zero). The second signal 914 is based on the signal to be amplified and has an amplitude that increases across the second output peak amplitude range from a third amplitude 1130 to a fourth amplitude 1132. The third signal 928 is substantially zero in this range.

In some examples, the method 1000 also comprises operating the amplifier circuit in a third output peak amplitude range 1134 of the amplifier circuit. The third output peak amplitude range 1134 is higher than the second output peak amplitude range 1126. In the third output peak amplitude range 1134, the first signal 904 is based on the signal to be amplified and has an amplitude that increases across the third output peak amplitude range 1134 from substantially zero to the first amplitude 1112 and is of opposite phase to the first signal in the first output peak amplitude range. That is, for example, the first signal 904 in the third range 1134 is effectively in antiphase to the first signal 904 in the first range 1108. The second signal 914 is based on the signal to be amplified and has an amplitude that increases across the third output peak amplitude range 1134 from the fourth amplitude 1132 to a fifth amplitude 1136, and the third signal 928 is substantially zero.

The method 1000 also comprises, in some examples, operating the amplifier circuit in a fourth output peak amplitude range 1138 of the amplifier circuit, wherein the fourth output peak amplitude range 1138 is higher than the third output peak amplitude range 1134. In the fourth output peak amplitude range 1138, the first signal 904 is based on the signal to be amplified and has an amplitude that decreases across the fourth output peak amplitude range 1138 from the first amplitude 1112 to substantially zero and is of opposite phase to the first signal in the first output peak amplitude range. The second signal 914 is based on the signal to be amplified and has an amplitude that decreases across the fourth output peak amplitude range 1138 from the fifth amplitude 1136 to the fourth amplitude 1132, and the third signal 928 has an amplitude that increases across the fourth output peak amplitude range 1138 from a sixth amplitude 1140 to a seventh amplitude 1142.

In some examples, the method 1000 further comprises operating the amplifier circuit in a first auxiliary output peak amplitude range 1144 of the amplifier circuit. The first auxiliary output peak amplitude range 1144 is higher than the first output peak amplitude range 1108 and lower than the second output peak amplitude range 1126. In the first auxiliary output peak amplitude range 1144, the first signal 904 is based on the signal to be amplified and has the first amplitude 1112 (i.e. is substantially constant across this range). The second signal 914 is based on the signal to be amplified and has an amplitude that increases across the first auxiliary output peak amplitude range 1144 from substantially zero to the third amplitude 1130, and the third signal 928 is substantially zero. In some examples, the rate of increase of the second signal 914 across the second output peak amplitude range 1126 from the third amplitude 1130 to the fourth amplitude 1132 is higher than a rate of increase of the second signal 914 across the first auxiliary output peak amplitude range 1144 from substantially zero to the third amplitude 1130. Additionally or alternatively, the rate of increase of the second signal 914 across the third output peak amplitude range 1134 from the fourth amplitude 1132 to the fifth amplitude 1136 is higher than a rate of increase of the second signal 914 across the first auxiliary output peak amplitude range 1144 from substantially zero to the third amplitude 1130. This may be for example to compensate for the decrease in the first signal 904 in the range 1126 and/or 1134.

In some examples, the first auxiliary output peak amplitude range is not present. In these cases, the third amplitude 1130 may be substantially zero.

In some examples, the method 1000 further comprises operating the amplifier circuit in a third auxiliary output peak amplitude range 1146 of the amplifier circuit. The third auxiliary output peak amplitude range 1146 is higher than the third output peak amplitude range 1134 and lower than the fourth output peak amplitude range 1138. In the third auxiliary output peak amplitude range 1146, the first signal 904 is based on the signal to be amplified and has the first amplitude 1112 (i.e. its amplitude is substantially constant over the range) and is of opposite phase to the first signal in the first output peak amplitude range 1108. The second signal is based on the signal to be amplified and has the fifth amplitude 1136 (i.e. its amplitude is substantially constant), and the third signal 928 is based on the signal to be amplified and has an amplitude that increases across the third auxiliary output peak amplitude range 1146 from substantially zero to the sixth amplitude 1140. In some particular examples, a rate of increase of the third signal 928 across the fourth output peak amplitude range 1138 is higher than a rate of increase of the third signal 928 across the third auxiliary output peak amplitude range 1146, for example to compensate for the decreasing second signal 914 and/or the decreasing (in amplitude) first signal 904.

In some examples, the method 1000 comprises operating the amplifier circuit in a fifth output peak amplitude range 1148 of the amplifier circuit, wherein the fifth output peak amplitude range 1148 is higher than the fourth output peak amplitude range 1138. In the fifth output peak amplitude range 1148, the first signal 904 is based on the signal to be amplified and has an amplitude that increases across the fifth output peak amplitude range 1148 from substantially zero to the first amplitude 1112. The second signal 914 is based on the signal to be amplified and has an amplitude that decreases across the fifth output peak amplitude range 1148 from the fourth amplitude 1132 to the third amplitude 1130, and the third signal 928 is based on the signal to be amplified and has an amplitude that increases across the fifth output peak amplitude range 1148 from the seventh amplitude 1142 to an eighth amplitude 1150.

In some examples, the method 1000 comprises operating the amplifier circuit in a sixth output peak amplitude range 1152 of the amplifier circuit, wherein the sixth output peak amplitude range 1152 is higher than the fifth output peak amplitude range 1148. In the sixth output peak amplitude range 1152, the first signal 904 is based on the signal to be amplified and has an amplitude that decreases across the sixth output peak amplitude range 1152 from the first amplitude 1112 to substantially zero. The second signal 914 is substantially zero, and the third signal 928 is based on the signal to be amplified and has an amplitude that increases across the sixth output peak amplitude range 1152 from a ninth amplitude 1154 to a tenth amplitude 1156. In particular examples, the method 1000 may comprise operating the amplifier circuit in a fifth auxiliary output peak amplitude range 1158 of the amplifier circuit. The fifth auxiliary output peak amplitude range 1158 is higher than the fifth output peak amplitude range 1148 and lower than the sixth output peak amplitude range 1152. In the fifth auxiliary output peak amplitude range 1158, the first signal 904 is based on the signal to be amplified and has the first amplitude 1112. The second signal 914 is based on the signal to be amplified and has an amplitude that decreases across the fifth auxiliary output peak amplitude range 1158 from the third amplitude 1130 to substantially zero, and the third signal 928 is based on the signal to be amplified and has an amplitude that increases across the fifth auxiliary output peak amplitude range 1158 from the eighth amplitude 1150 to the ninth amplitude 1154. However, in some examples where the fifth auxiliary output peak amplitude range 1158 is not present, the eighth amplitude 1150 may be substantially equal to the ninth amplitude 1154.

In some examples, the method 1000 further comprises operating the amplifier circuit in a seventh output peak amplitude range 1160 of the amplifier circuit. The seventh output peak amplitude range 1160 is higher than the sixth output peak amplitude range 1152. In the seventh output peak amplitude range 1160, the first signal 904 is based on the signal to be amplified and has an amplitude that increases across the seventh output peak amplitude range 1160 from substantially zero to the first amplitude 1112 and is of opposite phase to the first signal in the first output peak amplitude range 1108. The second signal 914 is substantially zero, and the third signal 928 is based on the signal to be amplified and has an amplitude that increases across the seventh output peak amplitude range 1160 from the tenth amplitude 1156 to an eleventh amplitude 1162. In particular examples, the method 1000 may further comprise operating the amplifier circuit in an eighth output peak amplitude range 1164 of the amplifier circuit, wherein the eighth output peak amplitude range 1164 is higher than the seventh output peak amplitude range 1160. In the eighth output peak amplitude range 1164, the first signal 904 is based on the signal to be amplified and has an amplitude that decreases across the eighth output peak amplitude range 1164 from the first amplitude 1112 to substantially zero and is of opposite phase to the first signal in the first output peak amplitude range 1108. The second signal 914 is based on the signal to be amplified and has an amplitude that increases across the eighth output peak amplitude range 1164 from the third amplitude 1130 to the fourth amplitude 1132 and is of opposite phase to the second signal in the second output peak amplitude range 1126, and the third signal 928 is based on the signal to be amplified and has an amplitude that increases across the eighth output peak amplitude range 1164 from a twelfth amplitude 1166 to a thirteenth amplitude 1168. In particular examples, the method 1000 may comprise operating the amplifier circuit in a seventh auxiliary output peak amplitude range 1170 of the amplifier circuit. The seventh auxiliary output peak amplitude range 1170 is higher than the seventh output peak amplitude range 1160 and lower than the eighth output peak amplitude range 1164. In the seventh auxiliary output peak amplitude range 1170, the first signal 904 is based on the signal to be amplified and has the first amplitude 1112 and is of opposite phase to the first signal in the first output peak amplitude range. The second signal 914 is based on the signal to be amplified and has an amplitude that increases across the eighth output peak amplitude range 1170 from substantially zero to the third amplitude 1130 and is of opposite phase to the second signal in the second output peak amplitude range 1126, and the third signal 928 is based on the signal to be amplified and has an amplitude that increases across the eighth output peak amplitude range 1170 from the eleventh amplitude 1162 to the twelfth amplitude 1166. However, in examples where the seventh auxiliary output peak amplitude range 1170 is not present, the eleventh amplitude 1162 may be substantially equal to the twelfth amplitude 1166.

In some examples, the method 1000 may comprise operating the amplifier circuit in an additional output peak amplitude range 1172 of the amplifier circuit. The additional output peak amplitude range 1172 is higher than the eighth output peak amplitude range 1164. In the additional output peak amplitude range 1172, the first signal 904 is based on the signal to be amplified and has an amplitude that increases from substantially zero to the first amplitude 1112 across the range. The second signal 914 is based on the signal to be amplified and has an amplitude that increases across the range 1172 from the fourth amplitude 1132 to the fifth amplitude 1136 and is of opposite phase to the second signal in the second output peak amplitude range 1126, and the third signal 928 is based on the signal to be amplified and has an amplitude that increases across the additional output peak amplitude range 1172 from the thirteenth amplitude 1168 to a fourteenth amplitude 1174.

It can be seen from the (normalized) efficiency curve 1106 that there is an efficiency maximum at the upper end of each of the ranges shown in Figure 11. Thus, for example, there may be up to thirteen efficiency maxima depending on the number of ranges used in a particular example implementation of the operation of the amplifier circuit (such as for example the amplifier circuit 900).

The method 1000 comprise generating the first, second and third signals based on the signal to be amplified. For example, these may be generated from digital signals (e.g. outputs from respective DACs). Each signal may be based on a signal to be amplified, i.e. scaled by a respective amount and/or inverted (e.g. inverted where described above).

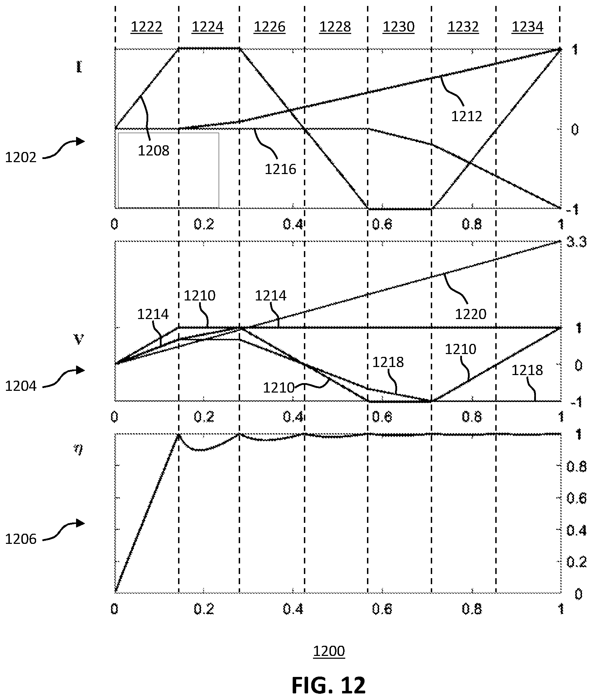

Figure 12 is a graph showing an example of signals in the amplifier circuit, such as for example the amplifier circuit 900 shown in Figure 9 or the amplifier circuit 600 shown in Figure 6, during operation in accordance with another example method. In particular, the signals and graphs shown include currents 1202, voltages 1204 and efficiency 1206 in the amplifier circuit. The graphs include a first signal 904 (illustrated as current signal 1208), and corresponding output voltage 1210 of the first amplifier 902; a third signal 928 (illustrated as current signal 1212), and corresponding output voltage 1214 of the second amplifier 912; and a second signal 914 (illustrated as current signal 1216), and corresponding output voltage 1218 of the first amplifier 902. Overall output voltage of the amplifier circuit is shown as signal 1220. The amplifier circuit operates in increasing output peak amplitude ranges 1222, 1224, 1226, 1228, 1230, 1232 and 1234. The first current signal 1208 increases in the first range 1222, remains substantially constant in the second range 1224, decreases in the third range 1226, increases and is in antiphase in fourth range 1228, remains substantially constant and in antiphase in fifth range 1230, decreases and is in antiphase in sixth range 1232 and increases and is in-phase in seventh range 1234. The second current signal 1212 remains substantially at zero in the first range 1222, increases in the second range 1224, and increases at a faster pace in ranges 1226, 1228, 1230, 1232 and 1234 compared to range 1224. The third signal remains substantially at zero in ranges 1222, 1224, 1226 and 1228, increases and is in antiphase in range 1230, and increases (in antiphase) at a faster pace in ranges 1232 and 1234 compared to range 1230. This may represent a simpler implementation than that shown in Figure 11, and hence may in some examples have fewer or simpler implementation components. A further simplification can be made for example by omitting the second range 1224 and/or the fifth range 1230.

This example may achieve advantages such as for example lower complexity and low impedance ratios compared to the examples shown in Figure 11. The complexity reduction may be achieved at least in part by having phase reversals (i.e. both in-phase and antiphase parts) only for the signal provided from the first amplifier. This may mean for example that the amplifiers can instead be driven more easily, for example with the same linear input signal and different class C biases.

In a particular implementation, which is operated in accordance with the signals shown in Figure 12, an amplifier circuit such as that shown in Figure 9 may have 4.5 times higher impedance level at the first amplifier (e.g. amplifier 902) than at the other amplifiers. This amplifier may have up to seven efficiency maxima as shown by the graph 1206 in Figure 12. The total output power is 49 times the power of the first amplifier 902, with the other amplifiers 912 and 926amplifiers having 15 and 33 times the first amplifier 902 power respectively.

It is noted that the relative and absolute amplitudes shown in the graphs of Figures 8, 11 and 12 are merely illustrative examples and that the amplitudes may be different in other implementations and/or may vary between different signals (e.g. between the first and second signals).

Some examples may employ differently shaped drive signals to the different amplifier stages, e.g. to form the first, second and/or third amplifier input signals described herein. That is, for example, the input signal (the signal to be amplified by the amplifier circuit according to examples of this disclosure) may be applied at different amplitudes or signal levels to the different amplifiers, and also in some cases in antiphase. This can for example be achieved by digital processing. In some example implementations, each different signal provided to each amplifier may require an associated DAC. If the number of digitally controlled drive signals is limited, analog circuitry could instead be used in some examples for shaping the output currents. As a method for analog shaping of the amplifier signals, class C biasing, i.e. more negative DC bias, can be used. This shaping can then be done for example directly in one or more transistors in the amplifiers with a linear drive signal applied, and may also provide higher DC to RF current conversion efficiency than class B or class AB biasing. Pre-shaping by class C biasing of amplifier transistors may also be used, together with a less negative bias in one or more of the transistors.

The analog shaping of the drive signal to the first amplifier in a four-range amplifier circuit, for example as illustrated by Figure 8, can be done by using a class C biased amplifier for the first amplifier, driven by the linear input signal, added in antiphase with the linear input signal itself. In this way the negative amplitude slope in ranges 822 and 832 may be achieved by a class C biased amplifier with bias set so that it starts delivering output current at the lower end of range 822. The flat amplitude of range 830 can be achieved by another such class C amplifier with a breakpoint at the lower end of range 830. Another option may be for example to use the natural compression/saturation of a transistor in the first amplifier, which may be at full output amplitude in range 830, since this requires no extra class C amplifiers.

The addition of the class C signal to the linear signal can be done in some examples by injection of the output current of the class C biased transistor directly into the drive signal path, if it is properly backward terminated or has a buffer stage.

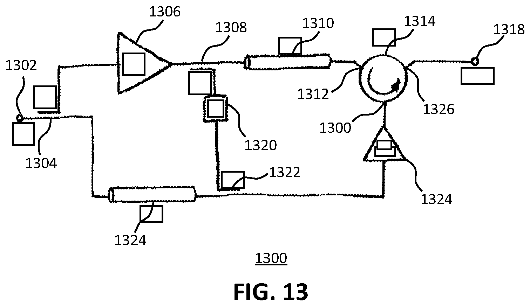

The principles disclosed herein can also be applied in some examples to other amplifier types. Figure 13 shows an example of an amplifier circuit 1300, where for example a circulator-coupled amplifier stage can also be used as an error amplifier in a feedforward system. This is due to two of the properties described above, namely that a signal from a preceding amplifier passes through largely unaffected to the output of the amplifier circuit, and that a signal inserted by the circulator-coupled amplifier mainly (or entirely) goes towards the output. Therefore, a preceding, main, amplifier's operation will not be substantially affected by a correction signal from the circulator-coupled amplifier.

The amplifier circuit 1300 includes an input 1302 for receiving a signal to be amplified, which is provided via a first coupler 1304 to a first amplifier 1306. The output of the first amplifier 1306 is provided via a second coupler 1308 and a first transmission line 1310 to a first port 1312 of a circulator 1314. A third port 1316 of the circulator 1314 is connected to an output 1318 of the amplifier circuit 1300.

Part of the signal output from first amplifier 1306 is tapped off by the second coupler 1308 and provided via an optional signal modification block, which may modify the amplitude and/or phase of the tapped off signal, to a third coupler 1322.

Part of the signal provided to the input 1302 is tapped off by coupler 1304 and is provided via second transmission line 1324 via the third coupler 1322 to a second amplifier 1324, also referred to in some examples as the error amplifier. The output of the error amplifier is provided to a second port 1326 of the circulator 1314.

Since the signals from both the first amplifier 1306 and second (error) amplifier 1324 go to the output 1318, with the signal from the first amplifier 1306 being reflected off the output node of the error amplifier 1324, an inserted error signal that is a negative copy of an identified error in the first amplifier 1306's output will cancel out this error. This may be particularly the case for example if operation is sufficiently linear. For example, the signal level at the second amplifier 1324 may be below saturation/compression.

In operation, an error signal is obtained as follows. A part of the output signal from the first amplifier 1306 is tapped off by the second coupler 1308 and is provided via optional signal processing block 1320 to a third coupler 1322, where it is subtracted from a reference signal (from first coupler 1304) at the second coupler 1322, where the reference signal may be for example a copy or scaled copy of the input signal provided to input 1304. The transmission line 1324 can be used to compensate for the delay through the first amplifier 1306, second coupler 1308 and optional signal modification block 1320. The error signal at the output of the third coupler 1322 is used to drive the second (error) amplifier 1324, which inserts the amplified error signal through the circulator 1314. The transmission line 1310 can be used to compensate for the delay through the optional signal modification block 1320, third coupler 1322 and second amplifier 1324.

The couplers described above may each comprise for example a directional coupler or alternatively a power splitter.

### References

[1] Shepphard et al., "An Efficient Broadband Reconfigurable Power Amplifier Using Active Load Modulation," IEEE Microwave and Wireless Components Letters, vol. 26, no. 6, June 2016
[2] Pednekar et al., "Analysis and Design of a Doherty-Like RF-Input Load Modulated Balanced Amplifier," IEEE TRANSACTIONS ON MICROWAVE THEORY AND TECHNIQUES, VOL. 66, NO. 12, DECEMBER 2018, pp. 5322-5335

## Claims

1. An amplifier circuit (500)comprising:
a first amplifier (502) configured to receive a first signal (504), wherein the first signal is based on a signal to be amplified, and to provide a first amplified signal (506) to a first port (508) of a first circulator (510); and
a second amplifier (512) configured to receive a second signal (514), wherein the second signal is based on the signal to be amplified, and to provide a second amplified signal (516) to a second port (518) of the first circulator (510),
, wherein the first circulator (510) is configured to output the first amplified signal (506) provided to the first port (508) of the first circulator (510) from the second port (518) of the first circulator (510)
wherein a third port (520)of the first circulator (510) comprises an output (522) of the amplifier circuit (500) wherein the first circulator (510) is configured to output the second amplified signal (516) provided to the second port (518) of the first circulator (510) from the third port (520) of the first circulator (510)
**characterized in that** the amplifier circuit is further configured to be operated in a first output peak amplitude range of the amplifier circuit wherein, in the first output peak amplitude range, the first signal has an amplitude that increases across the first output peak amplitude range from substantially zero to a first amplitude, and the second signal is substantially zero.

2. The amplifier circuit of any of claim 1, comprising a transformer in a signal path of the first amplified signal between the first amplifier and the first port of the first circulator.

3. The amplifier circuit of any of claims 1 to 2, comprising a transformer in a signal path of the second amplified signal between the second amplifier and the second port of the first circulator.

4. The amplifier circuit of any of claims 1 to 3, wherein the first amplifier is an amplifier circuit that comprises:
a third amplifier configured to receive the first signal and to provide a third amplified signal to a first port of a second circulator; and
a fourth amplifier (610) configured to receive a fourth signal based on a signal to be amplified and to provide a fourth amplified signal to a second port of the second circulator,
wherein a third port of the second circulator is connected to the first port of the first circulator to provide the first amplified signal to the first port of the first circulator.

5. The amplifier circuit of claim 4, comprising a transformer in a signal path between the third port of the second circulator and the first port of the first circulator.

6. A method of operating an amplifier circuit, wherein the amplifier circuit comprises:
a first amplifier (502) configured to receive a first signal and to provide a first amplified signal to a first port of a first circulator;
a second amplifier (512) configured to receive a second signal and to provide a second amplified signal to a second port of the first circulator,
wherein a third port of the first circulator is connected to a first port of a second circulator (608);
and the amplifier circuit further comprises:
a third amplifier (602)configured to receive a third signal and to provide a third amplified signal (604)to a second port of the second circulator; and
wherein a third port of the second circulator comprises an output of the amplifier circuit;
and the method comprises:
operating (702) the amplifier circuit in a first output peak amplitude range of the amplifier circuit wherein, in the first output peak amplitude range (808), the first signal (504) is based on a signal to be amplified and has an amplitude that increases across the first output peak amplitude range from substantially zero to a first amplitude (814), the second signal is substantially zero, and the third signal is substantially zero and the method further comprising generating the first, second and third signals based on the signal to be amplified.

7. The method of claim 6, further comprising operating the amplifier circuit in a second output peak amplitude range of the amplifier circuit, wherein the second output peak amplitude range is higher than the first output peak amplitude range and wherein, in the second output peak amplitude range, the first signal is based on the signal to be amplified and has an amplitude that decreases across the second output peak amplitude range from the first amplitude to a second amplitude, the second signal is based on the signal to be amplified and has an amplitude that increases across the second output peak amplitude range from a third amplitude to a fourth amplitude, and the third signal is substantially zero.

8. The method of claim 6 or 7, further comprising operating the amplifier circuit in a third output peak amplitude range of the amplifier circuit, wherein the third output peak amplitude range is higher than the second output peak amplitude range and wherein, in the third output peak amplitude range, the first signal is based on the signal to be amplified and has an amplitude that increases across the third output peak amplitude range from substantially zero to the first amplitude and is of opposite phase to the first signal in the first output peak amplitude range, the second signal is based on the signal to be amplified and has an amplitude that increases across the third output peak amplitude range from the fourth amplitude to a fifth amplitude, and the third signal is substantially zero.

9. The method of any of claims 6 to 8, further comprising operating the amplifier circuit in a fourth output peak amplitude range of the amplifier circuit, wherein the fourth output peak amplitude range is higher than the third output peak amplitude range and wherein, in the fourth output peak amplitude range, the first signal is based on the signal to be amplified and has an amplitude that decreases across the fourth output peak amplitude range from the first amplitude to substantially zero and is of opposite phase to the first signal in the first output peak amplitude range, the second signal is based on the signal to be amplified and has an amplitude that decreases across the fourth output peak amplitude range from the fifth amplitude to the fourth amplitude, and the and the third signal has an amplitude that increases across the fourth output peak amplitude range from a sixth amplitude to a seventh amplitude.

## Patentansprüche

1. Verstärkerschaltung (500), die Folgendes umfasst:
einen ersten Verstärker (502), der dazu konfiguriert ist, ein erstes Signal (504) zu empfangen, wobei das erste Signal auf einem zu verstärkenden Signal basiert, und ein erstes verstärktes Signal (506) an einen ersten Anschluss (508) eines ersten Zirkulators (510) bereitzustellen; und
einen zweiten Verstärker (512), der dazu konfiguriert ist, ein zweites Signal (514) zu empfangen, wobei das zweite Signal auf dem zu verstärkenden Signal basiert, und ein zweites verstärktes Signal (516) an einen zweiten Anschluss (518) des ersten Zirkulators (510) bereitzustellen, wobei der erste Zirkulator (510) dazu konfiguriert ist, das erste verstärkte Signal (506), das dem ersten Anschluss (508) des ersten Zirkulators (510) bereitgestellt wird, von dem zweiten Anschluss (518) des ersten Zirkulators (510) auszugeben,
wobei ein dritter Anschluss (520) des ersten Zirkulators (510) einen Ausgang (522) der Verstärkerschaltung (500) umfasst, wobei der erste Zirkulator (510) dazu konfiguriert ist, das zweite verstärkte Signal (516), das dem zweiten Anschluss (518) des ersten Zirkulators (510) bereitgestellt wird, von dem dritten Anschluss (520) des ersten Zirkulators (510) auszugeben,
**dadurch gekennzeichnet, dass** die Verstärkerschaltung weiter dazu konfiguriert ist, in einem ersten Ausgangsspitzenamplitudenbereich der Verstärkerschaltung betrieben zu werden, wobei in dem ersten Ausgangsspitzenamplitudenbereich das erste Signal eine Amplitude aufweist, die über den ersten Ausgangsspitzenamplitudenbereich von im Wesentlichen null bis zu einer ersten Amplitude zunimmt, und das zweite Signal im Wesentlichen null ist.

2. Verstärkerschaltung nach Anspruch 1, die einen Transformator in einem Signalpfad des ersten verstärkten Signals zwischen dem ersten Verstärker und dem ersten Anschluss des ersten Zirkulators umfasst.

3. Verstärkerschaltung nach einem der Ansprüche 1 oder 2, die einen Transformator in einem Signalweg des zweiten verstärkten Signals zwischen dem zweiten Verstärker und dem zweiten Anschluss des ersten Zirkulators umfasst.

4. Verstärkerschaltung nach einem der Ansprüche 1 bis 3, wobei der erste Verstärker eine Verstärkerschaltung ist, die Folgendes umfasst:
einen dritten Verstärker, der dazu konfiguriert ist, das erste Signal zu empfangen und ein drittes verstärktes Signal an einen ersten Anschluss eines zweiten Zirkulators bereitzustellen; und
einen vierten Verstärker (610), der dazu konfiguriert ist, ein viertes Signal basierend auf einem zu verstärkenden Signals zu empfangen und ein viertes verstärktes Signal an einen zweiten Anschluss des zweiten Zirkulators bereitzustellen,
wobei ein dritter Anschluss des zweiten Zirkulators mit dem ersten Anschluss des ersten Zirkulators verbunden ist, um das erste verstärkte Signal an den ersten Anschluss des ersten Zirkulators bereitzustellen.

5. Verstärkerschaltung nach Anspruch 4, die einen Transformator in einem Signalpfad zwischen dem dritten Anschluss des zweiten Zirkulators und dem ersten Anschluss des ersten Zirkulators umfasst.

6. Verfahren zum Betreiben einer Verstärkerschaltung, wobei die Verstärkerschaltung Folgendes umfasst:
einen ersten Verstärker (502), der dazu konfiguriert ist, ein erstes Signal zu empfangen und ein erstes verstärktes Signal an einen ersten Anschluss eines ersten Zirkulators bereitzustellen;
einen zweiten Verstärker (512), der dazu konfiguriert ist, ein zweites Signal zu empfangen und ein zweites verstärktes Signal an einen zweiten Anschluss des ersten Zirkulators bereitzustellen,
wobei ein dritter Anschluss des ersten Zirkulators mit einem ersten Anschluss eines zweiten Zirkulators verbunden ist (608);
und die Verstärkerschaltung weiter Folgendes umfasst:
einen dritten Verstärker (602), der dazu konfiguriert ist, ein drittes Signal zu empfangen und ein drittes verstärktes Signal (604) an einen zweiten Anschluss des zweiten Zirkulators bereitzustellen; und
wobei ein dritter Anschluss des zweiten Zirkulators einen Ausgang der Verstärkerschaltung umfasst;
und wobei das Verfahren Folgendes umfasst:
Betreiben (702) der Verstärkerschaltung in einem ersten Ausgangsspitzenamplitudenbereich der Verstärkerschaltung, wobei in dem ersten Ausgangsspitzenamplitudenbereich (808) das erste Signal (504) auf einem zu verstärkenden Signal basiert und eine Amplitude aufweist, die über den ersten Ausgangsspitzenamplitudenbereich von im Wesentlichen null auf eine erste Amplitude (814) zunimmt, das zweite Signal im Wesentlichen null ist, und das dritte Signal im Wesentlichen null ist, wobei das Verfahren weiter das Erzeugen des ersten, zweiten und dritten Signals basierend auf dem zu verstärkenden Signal umfasst.

7. Verfahren nach Anspruch 6, das weiter das Betreiben der Verstärkerschaltung in einem zweiten Ausgangsspitzenamplitudenbereich der Verstärkerschaltung umfasst, wobei der zweite Ausgangsspitzenamplitudenbereich höher ist als der erste Ausgangsspitzenamplitudenbereich und wobei in dem zweiten Ausgangsspitzenamplitudenbereich das erste Signal auf dem zu verstärkenden Signal basiert und eine Amplitude aufweist, die über den zweiten Ausgangsspitzenamplitudenbereich von der ersten Amplitude auf eine zweite Amplitude abnimmt, das zweite Signal auf dem zu verstärkenden Signal basiert und eine Amplitude aufweist, die über den zweiten Ausgangsspitzenamplitudenbereich von einer dritten Amplitude auf eine vierte Amplitude zunimmt, und das dritte Signal im Wesentlichen null ist.

8. Verfahren nach Anspruch 6 oder 7, das weiter das Betreiben der Verstärkerschaltung in einem dritten Ausgangsspitzenamplitudenbereich der Verstärkerschaltung umfasst, wobei der dritte Ausgangsspitzenamplitudenbereich höher ist als der zweite Ausgangsspitzenamplitudenbereich, und wobei in dem dritten Ausgangsspitzenamplitudenbereich das erste Signal auf dem zu verstärkenden Signal basiert und eine Amplitude aufweist, die über den dritten Ausgangsspitzenamplitudenbereich von im Wesentlichen null bis zu der ersten Amplitude zunimmt und dem ersten Signal in dem ersten Ausgangsspitzenamplitudenbereich entgegengesetzte Phase aufweist, das zweite Signal auf dem zu verstärkenden Signal basiert und eine Amplitude aufweist, die über den dritten Ausgangsspitzenamplitudenbereich von der vierten Amplitude bis zu einer fünften Amplitude zunimmt, und das dritte Signal im Wesentlichen null ist.

9. Verfahren nach einem der Ansprüche 6 bis 8, das weiter das Betreiben der Verstärkerschaltung in einem vierten Ausgangsspitzenamplitudenbereich der Verstärkerschaltung umfasst, wobei der vierte Ausgangsspitzenamplitudenbereich höher ist als der dritte Ausgangsspitzenamplitudenbereich, und wobei in dem vierten Ausgangsspitzenamplitudenbereich das erste Signal auf dem zu verstärkenden Signal basiert und eine Amplitude aufweist, die über den vierten Ausgangsspitzenamplitudenbereich von der ersten Amplitude auf im Wesentlichen null abnimmt und eine dem ersten Signal in dem ersten Ausgangsspitzenamplitudenbereich entgegengesetzte Phase aufweist, das zweite Signal auf dem zu verstärkenden Signal basiert und eine Amplitude aufweist, die über den vierten Ausgangsspitzenamplitudenbereich von der fünften Amplitude auf die vierte Amplitude abnimmt, und das dritte Signal eine Amplitude aufweist, die über den vierten Ausgangsspitzenamplitudenbereich von einer sechsten Amplitude auf eine siebte Amplitude zunimmt.

## Revendications

1. Circuit amplificateur (500), comprenant :
un premier amplificateur (502) configuré pour recevoir un premier signal (504), dans lequel le premier signal est basé sur un signal à amplifier, et pour fournir un premier signal amplifié (506) à un premier port (508) d'un premier circulateur (510) ; et
un second amplificateur (512) configuré pour recevoir un deuxième signal (514), dans lequel le deuxième signal est basé sur le signal à amplifier, et pour fournir un deuxième signal amplifié (516) à un deuxième port (518) du premier circulateur (510), dans lequel le premier circulateur (510) est configuré pour délivrer en sortie le premier signal amplifié (506) fourni au premier port (508) du premier circulateur (510) depuis le deuxième port (518) du premier circulateur (510),
dans lequel un troisième port (520) du premier circulateur (510) comprend une sortie (522) du circuit amplificateur (500), dans lequel le premier circulateur (510) est configuré pour délivrer en sortie le deuxième signal amplifié (516) fourni au deuxième port (518) du premier circulateur (510) à partir du troisième port (520) du premier circulateur (510),
**caractérisé en ce que** le circuit amplificateur est en outre configuré pour fonctionner dans une première plage d'amplitude de crête de sortie du circuit amplificateur, dans lequel, dans la première plage d'amplitude de crête de sortie, le premier signal présente une amplitude qui augmente sur toute la première plage d'amplitude de crête de sortie, de sensiblement zéro à une première amplitude, et le deuxième signal est sensiblement nul.

2. Circuit amplificateur selon la revendication 1, comprenant un transformateur dans un trajet de signal du premier signal amplifié entre le premier amplificateur et le premier port du premier circulateur.

3. Circuit amplificateur selon l'une quelconque des revendications 1 à 2, comprenant un transformateur dans un trajet de signal du deuxième signal amplifié entre le second amplificateur et le deuxième port du premier circulateur.

4. Circuit amplificateur selon l'une quelconque des revendications 1 à 3, dans lequel le premier amplificateur est un circuit amplificateur qui comprend :
un troisième amplificateur configuré pour recevoir le premier signal et pour fournir un troisième signal amplifié à un premier port d'un second circulateur ; et
un quatrième amplificateur (610) configuré pour recevoir un quatrième signal basé sur un signal à amplifier et pour fournir un quatrième signal amplifié à un deuxième port du second circulateur,
dans lequel un troisième port du second circulateur est connecté au premier port du premier circulateur pour fournir le premier signal amplifié au premier port du premier circulateur.

5. Circuit amplificateur selon la revendication 4, comprenant un transformateur dans un trajet de signal entre le troisième port du second circulateur et le premier port du premier circulateur.

6. Procédé de fonctionnement d'un circuit amplificateur, dans lequel le circuit amplificateur comprend :
un premier amplificateur (502) configuré pour recevoir un premier signal et pour fournir un premier signal amplifié à un premier port d'un premier circulateur ;
un second amplificateur (512) configuré pour recevoir un deuxième signal et pour fournir un deuxième signal amplifié à un deuxième port du premier circulateur,
dans lequel un troisième port du premier circulateur est connecté à un premier port d'un second circulateur (608) ;
et le circuit amplificateur comprend en outre :
un troisième amplificateur (602) configuré pour recevoir un troisième signal et pour fournir un troisième signal amplifié (604) à un deuxième port du second circulateur ; et
dans lequel un troisième port du second circulateur comprend une sortie du circuit amplificateur ;
et le procédé comprend :
le fonctionnement (702) du circuit amplificateur dans une première plage d'amplitude de crête de sortie du circuit amplificateur, dans lequel, dans la première plage d'amplitude de crête de sortie (808), le premier signal (504) est basé sur un signal à amplifier et présente une amplitude qui augmente sur la première plage d'amplitude de crête de sortie de sensiblement zéro à une première amplitude (814), le deuxième signal est sensiblement nul et le troisième signal est sensiblement nul, et le procédé comprend en outre la génération des premier, deuxième et troisième signaux sur la base du signal à amplifier.

7. Procédé selon la revendication 6, comprenant en outre le fonctionnement du circuit amplificateur dans une seconde plage d'amplitude de crête de sortie du circuit amplificateur, dans lequel la seconde plage d'amplitude de crête de sortie est supérieure à la première plage d'amplitude de crête de sortie et dans lequel, dans la seconde plage d'amplitude de crête de sortie, le premier signal est basé sur le signal à amplifier et présente une amplitude qui diminue sur toute la seconde plage d'amplitude de crête de sortie, de la première amplitude à une deuxième amplitude, le second signal est basé sur le signal à amplifier et présente une amplitude qui augmente sur toute la seconde plage d'amplitude de crête de sortie, d'une troisième amplitude à une quatrième amplitude, et le troisième signal est sensiblement nul.

8. Procédé selon la revendication 6 ou 7 comprenant en outre le fonctionnement du circuit amplificateur dans une troisième plage d'amplitude de crête de sortie du circuit amplificateur, dans lequel la troisième plage d'amplitude de crête de sortie est supérieure à la deuxième plage d'amplitude de crête de sortie et dans lequel, dans la troisième plage d'amplitude de crête de sortie, le premier signal est basé sur le signal à amplifier et présente une amplitude qui augmente sur toute la plage d'amplitude de crête de sortie, de sensiblement zéro à la première amplitude, et est en opposition de phase avec le premier signal dans la première plage d'amplitude de crête de sortie, le deuxième signal est basé sur le signal à amplifier et présente une amplitude qui augmente sur toute la plage d'amplitude de crête de sortie, de la quatrième amplitude à une cinquième amplitude, et le troisième signal est sensiblement nul.

9. Procédé selon l'une quelconque des revendications 6 à 8, comprenant en outre le fonctionnement du circuit amplificateur dans une quatrième plage d'amplitude de crête de sortie du circuit amplificateur, dans lequel la quatrième plage d'amplitude de crête de sortie est supérieure à la troisième plage d'amplitude de crête de sortie et dans lequel, dans la quatrième plage d'amplitude de crête de sortie, le premier signal est basé sur le signal à amplifier et présente une amplitude qui diminue sur toute la quatrième plage d'amplitude de crête de sortie, de la première amplitude à sensiblement zéro et est en opposition de phase avec le premier signal dans la première plage d'amplitude de crête de sortie, le deuxième signal est basé sur le signal à amplifier et présente une amplitude qui diminue sur toute la quatrième plage d'amplitude de crête de sortie, de la cinquième amplitude à la quatrième amplitude, et le troisième signal présente une amplitude qui augmente sur toute la quatrième plage d'amplitude de crête de sortie, de la sixième amplitude à la septième amplitude.
